# EUROPEAN PATENT SPECIFICATION

(11) **EP 3 014 673 B1**
(45) Date of publication and mention of the grant of the patent: **29.01.2025**
(21) Application number: 14818521.8
(22) Date of filing: 27.06.2014
(51) Int. Cl.: H10K 30/88, H10K 77/10, B32B 38/18, B29C 63/02

(54) **PREPARATION AND COATING OF THREE-DIMENSIONAL OBJECTS WITH ORGANIC OPTOELECTRONIC DEVICES INCLUDING ELECTRICITY-GENERATING ORGANIC PHOTOVOLTAIC FILMS USING THIN FLEXIBLE SUBSTRATES WITH PRESSURE-SENSITIVE ADHESIVES**
HERSTELLUNG UND BESCHICHTUNG DREIDIMENSIONALER OBJEKTE MIT ORGANISCHEN OPTOELEKTRONISCHEN VORRICHTUNGEN MIT STROMERZEUGENDEN ORGANISCHEN PHOTOVOLTAIKFILMEN MIT DÜNNEN, FLEXIBLEN SUBSTRATEN MIT DRUCKEMPFINDLICHEN KLEBSTOFFEN
PRÉPARATION ET REVÊTEMENT D'OBJETS TRIDIMENSIONNELS AVEC DES DISPOSITIFS OPTOÉLECTRONIQUES ORGANIQUES COMPRENANT DES FILMS PHOTOVOLTAÏQUES ORGANIQUES PRODUISANT DE L'ÉLECTRICITÉ À L'AIDE DE SUBSTRATS SOUPLES ET MINCES AVEC ADHÉSIF SENSIBLE À LA PRESSION

(30) Priority: 28.06.2013 US 201361841243 P; 28.06.2013 US 201361841244 P; 28.06.2013 US 201361841248 P; 28.06.2013 US 201361841247 P; 28.06.2013 US 201361841251 P; 02.07.2013 US 201361842355 P; 02.07.2013 US 201361842357 P; 02.07.2013 US 201361842365 P; 02.07.2013 US 201361842372 P; 02.07.2013 US 201361842375 P; 03.07.2013 US 201361842796 P; 03.07.2013 US 201361842803 P
(43) Date of publication of application: 04.05.2016
(73) Proprietor: SolarWindow Technologies, Inc., Scottsdale, AZ 85260 (US)
(72) Inventor: CONKLIN, John, Anthony, Apalachin, NY 13732 (US); HAMMOND, Scott, Ryan, Wheat Ridge, CO 80215 (US); THOMPSON, J., Patrick, Canton, GA 30114 (US)
(74) Representative: Murgitroyd & Company
(86) International application number: PCT/US2014/044655
(87) International publication number: WO 2014/210507

(56) References cited:
- US-A1- 2006 130 894
- US-A1- 2007 063 939
- US-A1- 2011 089 811
- US-A1- 2011 089 811
- US-A1- 2012 003 451
- US-A1- 2012 227 809
- US-B1- 6 197 418
- US-B1- 6 287 674
- KALTENBRUNNER M ET AL: "Ultrathin and lightweight organic solar cells with high flexibility", 1 April 2012 (2012-04-01), pages 1 - 7, XP002682520, ISSN: 2041-1723, Retrieved from the Internet <URL:http://www.nature.com/ncomms/journal/v3/n4/full/ncomms1772.html> [retrieved on 20120403], DOI: 10.1038/NCOMMS1772

## Description

### FIELD OF THE INVENTION

The present invention is directed to a method for the preparation and coating of three-dimensional objects with electricity-generating organic photovoltaic films, using thin, highly flexible substrates with pressure-sensitive adhesives, and more particularly, to doing so with semi-transparent organic photovoltaic films for see-through applications.

### BACKGROUND OF THE INVENTION

Processes for coating of three-dimensional objects are very limited in nature and scope. While coating of three-dimensional objects of arbitrary shapes is possible, via such coating techniques as: dip, curtain, rotating drum/fluidized bed, and spray, these techniques cannot provide the precise control of coating thickness, uniformity, and coverage required for organic optoelectronc devices such as organic photovoltaic (OPV), organic light-emitting diode (OLED), or organic electronic devices, such as organic thin-film transistors (OTFT). The science and technology of precise, thin film coating has mainly focused on planar surfaces, largely due to the issues with capillarity flow of fluids at curved surfaces.

XP002682520 (Kaltenbrunner M et al - Nature Communication, 1 April 2012, pages 1 to 7) describes a thin organic solar cell being transferred to a pre-stretched elastomer.

US 2006/130894 describes an illumination device including two substrates, wherein each of a photovoltaic element, an electroluminescence element and an electric energy storage element are located between the substrates and where one of the substrates is flexible.

US 2011/089811 describes a method for fabricating a semiconductor device having a peeled layer bonded to a base material with curvature.

### SUMMARY OF THE INVENTION

The present invention provides a transfer film and a method of manufacturing the transfer film as defined in the claims.

Despite the limitations in precisely coating three-dimensional objects, for a number of applications it would be desirable to prepare such objects with various optoelectronic devices. In particular, it would be desirable for a number of applications to be able to prepare OPV devices, and especially semi-transparent OPV devices, on curved surfaces and non-planar discrete objects. For example, it would be desirable to prepare semi-transparent OPV devices on curved window surfaces for application in military and commercial aircraft windows, which are the subject of Applicants' related applications entitled "Coatings for Aircraft Window Surfaces to Produce Electricity for Mission-Critical Systems on Military Aircraft" , "Coatings for Aircraft Fuselage Surfaces to Produce Electricity for Mission-Critical Systems on Military Aircraft", "Coatings for Aircraft Window Surfaces to Produce Electricity for Mission-Critical Systems and Maintenance Load on Commercial Aircraft" , and "Coatings for Aircraft Fuselage Surfaces to Produce Electricity for Mission-Critical Systems and Maintenance Load on Commercial Aircraft".

Arguably the most sophisticated technique for coating curved and other three-dimensional objects is spray coating, which has long been used for macro-scale coating of curved and three-dimensional objects such as auto body parts. Spray coating has also been used to precisely coat planar substrates for optoelectronic devices, particularly OPV devices, which require highly uniform thin films on the order of 100-200 nm. Despite this, the precise spray coating of curved and three-dimensional objects for optoelectronic devices, and particularly OPV devices, remains an attractive but elusive goal. As previously mentioned, the realities of capillarity flow at curved surfaces is the main barrier; fluids on curved surfaces are pumped away from the curvature by capillarity flow. If the object has uniform curvature, then capillarity flow is minimized and the main challenge becomes uniform application of fluid, which can be achieved by carefully controlled spray head movement. But for any object with varying curvature will always be subject to the effects of capillarity flow, regardless of the coating method.

OPV is an inherently flexible technology, however, which opens up new possibilities for obtaining three-dimensional coated objects. For example, Kaltenbrunner et. al (Nature Comm. DOI: 10.1038/ncomms1772) has demonstrated that by using very thin substrates, supported with temporary substrates and coated via conventional spin coating techniques, very flexible OPV devices can be prepared with comparable performance to those produced on rigid substrates, and the devices can survive extreme elastic deformations. The present application recognizes that the properties described by Kaltenbrunner et. al (Nature Comm. DOI: 10.1038/ncomms1772) can be adapted and taken advantage of to provide a novel method of production of three-dimensional optoelectronic devices, which is the subject of the exemplary embodiments of the present invention described herein.

The present invention recognizes that conventional methods for coating curved and three-dimensional objects lack the precision required for preparation of organic optoelectronic devices, particularly for the manufacture of OPV and semi-transparent OPV devices. It also recognizes that preparation of curved and three-dimensional objects coated with optoelectronic devices, and in particular OPV and semi-transparent OPV devices, is desirable for a number of applications.

These problems and others are addressed by the present invention as defined in the appended claims.

Other features and advantages of the present invention will become apparent to those skilled in the art upon review of the following detailed description and drawings.

### BRIEF DESCRIPTION OF THE DRAWINGS

These and other aspects and features of embodiments of the present invention will be better understood after a reading of the following detailed description, together with the attached drawings, wherein:
Figure 1 is a cross-sectional view of a pressure-sensitive adhesive-coated optoelectronic device, itself coated on a thin flexible substrate with a transfer release layer and backing layer, which can be used to prepare planar and curved optoelectronic device-covered three-dimensional objects, according to an exemplary embodiment not within the scope of this invention as claimed.
Figure 2 is a cross-sectional view of a curved, three-dimensional solid object coated with a conformal optoelectronic device, prepared via the pressure-sensitive adhesive method, according to an exemplary embodiment not within the scope of this invention as claimed.
Figure 3 is a cross-sectional view of a curved, three-dimensional semitransparent object, such as a window, coated with a conformal optoelectronic device, prepared via the pressure-sensitive adhesive method, according to an exemplary embodiment not within the scope of this invention as claimed.
Figure 4 is a cross-sectional view of a curved, three-dimensional solid object coated with a conformal organic photovoltaic device, prepared via the pressure-sensitive adhesive method, according to an exemplary embodiment of this invention.
Figure 5 is a cross-sectional view of a curved, three-dimensional semitransparent object, such as a window, coated with a conformal semitransparent organic photovoltaic device, prepared via the pressure-sensitive adhesive method, according to an exemplary embodiment of this invention.

### DETAILED DESCRIPTION OF THE EXEMPLARY EMBODIMENTS OF THE INVENTION

The present invention now is described more fully hereinafter with reference to the accompanying drawings, in which embodiments of the invention are shown. This invention may, however, be embodied in many different forms and should not be construed as limited to the embodiments set forth herein; rather, these embodiments are provided so that this disclosure will be thorough and complete, and will fully convey the scope of the invention, as defined in the claims, to those skilled in the art.

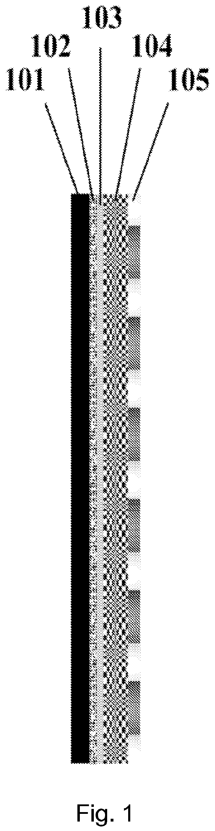

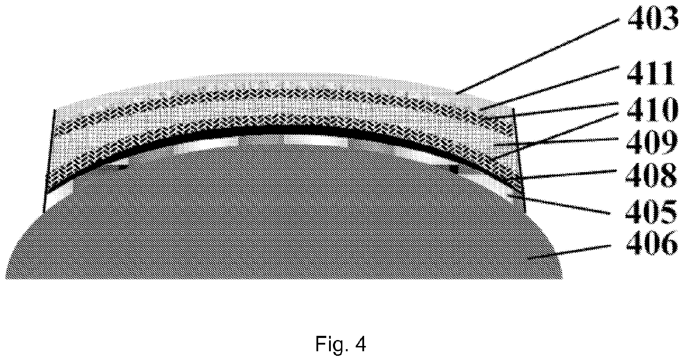

Referring now to the drawings, Figures 1-5 illustrate exemplary embodiments of the method for preparing three-dimensional objects coated with optoelectronic devices (Figures 1-3) and organic photovoltaic devices (Figures 4-5).

Referring to Fig. 1, which provides a cross-sectional view of a transfer film stack for the fabrication of organic optoelectronic device coatings for three-dimensional objects, the film is prepared upon a temporary base layer 101, in order to provide sufficient rigidity to allow conventional manufacturing techniques, including high-speed roll-to-roll coating. The base layer can include of glass or thick metal rigid substrates, flexible polymer or metal foils, or any convenient substrate material, depending on the chosen manufacturing methods. On top of the base layer is a transfer release layer 102 that allows easy removal of the base layer and transfer layer from the thin flexible substrate 103, which are all laminated together as known to those skilled in the art. The thin flexible substrate is any appropriate substrate material that is highly flexible and transparent, such as very thin polymer foils, including but not limited to polyethyleneterephthalate (PET). On top of this is coated an organic optoelectronic device, which may be any of a number of devices, including but not limited to: OPV and semi-transparent OPV devices (cells or modules), OLEDs, or organic electronic devices such as OTFTs, but which must be inherently flexible, and thus contain no highly crystalline materials. The coating and processing of these devices is known to those skilled in their respective arts, and in most cases is compatible with solution processing and high-throughput manufacturing techniques, including high-speed roll-to-roll or sheet-to-sheet production methods. The optoelectronic device is then coated with a pressure-sensitive adhesive 105 according to methods know to those skilled in the art. The resulting film comprising layers 101-105 can be used to transfer the optoelectronic device comprising layers 103-105 onto three-dimensional objects with arbitrary shapes and curvatures.

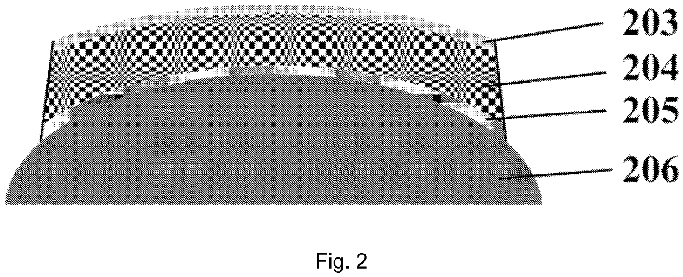

Referring to Fig. 2, which provides a cross-sectional view of a curved object coated with an organic optoelectronic device produced via the pressure-sensitive adhesive method, the base layer 206 includes an arbitrary solid object. Laminated onto the object using stretching and press-forming, with or without vacuum assistance in removing entrained air, is the optoelectronic device 204, which is adhered to the object using the pressure-sensitive adhesive layer 205, and is supported by the very thin, highly flexible substrate layer 203. The unique and inherent flexibility of organic optoelectronic devices allows lamination onto curved surfaces without significant disruption of device performance, and enables production of three-dimensional organic optoelectronic devices that would be difficult to produce via conventional coating techniques due to realities of capillarity flow on curved surfaces. This method enables organic optoelectronic devices to be laminated onto surfaces of arbitrary and changing curvature, which would be impossible via conventional solution coating techniques. While, in this exemplary embodiment, the method is necessarily a discrete process for the fabrication of each individual object, the intermediate transfer film (see Fig. 1) used to transfer the completed organic optoelectronic device onto the object can be produced in a continuous, high-throughput methodology. Not shown are any wires or other electrical contacts, or protective coatings that might prove beneficial.

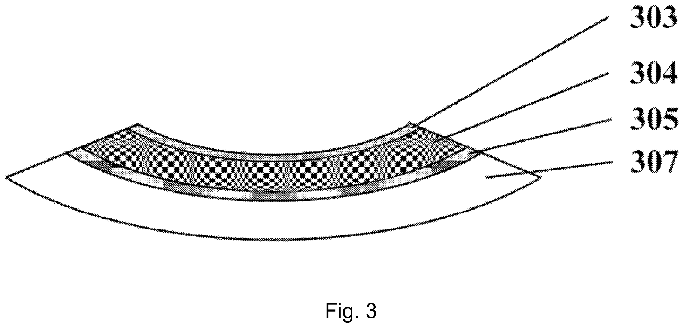

Referring to Fig. 3, which provides a cross-sectional view of a curved semitransparent object coated with an organic optoelectronic device produced via the pressure-sensitive adhesive method, the base layer 406 includes an arbitrary semitransparent object, such as a window. Laminated onto the object using stretching and press-forming, with or without vacuum assistance in removing entrained air, is the optoelectronic device 304, which is adhered to the object using the pressure-sensitive adhesive layer 305, and is supported by the very thin, highly flexible substrate layer 303. The unique and inherent flexibility of organic optoelectronic devices allows lamination onto curved surfaces without significant disruption of device performance, and enables production of three-dimensional organic optoelectronic devices that would be difficult to produce via conventional coating techniques due to realities of capillarity flow on curved surfaces. This method enables organic optoelectronic devices to be laminated onto surfaces of arbitrary and changing curvature, which would be impossible via conventional solution coating techniques. While, in this exemplary embodiment, the method is necessarily a discrete process for the fabrication of each individual object panel, the intermediate transfer film (see Fig. 1) used to transfer the completed organic optoelectronic device onto the object can be produced in a continuous, high-throughput methodology. Not shown are any wires or other electrical contacts, or protective coatings that might prove beneficial.

Referring to Fig. 4, which provides a cross-sectional view of a curved object coated with an OPV device, comprising one or more cells connecting in series and/or parallel, produced via the pressure-sensitive adhesive method, the base layer 406 includes an arbitrary solid object. Laminated onto the object via the pressure-sensitive adhesive 405 using stretching and press-forming, with or without vacuum assistance in removing entrained air, is the multilayer OPV device. Adhered directly to the base object is the metal electrode 408, which is ductile and reflective. On top of the metal electrode is a charge-collection layer 410 (hole or electron, depending on device polarity), which is used to make a selective contact to maximize OPV device performance, as known to those skilled in the art. These charge-collection layers are generally made of: transition metal oxides, which can be amorphous and thus flexible, or polymers or thin molecular layers, both of which are inherently flexible. In addition, these charge-collection layers can generally be made via high-throughput solution processed methods. On top of the first charge collection layer is the photoactive layer 409, generally a BHJ, which is generally made via solution techniques. On top of the BHJ is a second charge-collection layer 410, of opposite polarity as the previous collection layer. On top of the second charge-collection layer is a TC 411, to allow light to enter the device, while still transporting charge. Because the common TCO ITO is crystalline in nature, the TC must be an alternative material, one that is inherently flexible. Finally, on top is the very thin, highly flexible substrate 403. The unique and inherent flexibility of OPV devices allows lamination onto curved surfaces without significant disruption of device performance, and enables production of three-dimensional organic optoelectronic devices that would be difficult to produce via conventional coating techniques due to realities of capillarity flow on curved surfaces. This method enables OPV devices to be laminated onto surfaces of arbitrary and changing curvature, which would be impossible via conventional solution coating techniques. While, in this exemplary embodiment, the method is necessarily a discrete process for the fabrication of each individual object, the intermediate transfer film (see Fig. 1) used to transfer the completed OPV device onto the object can be produced in a continuous, high-throughput methodology. Not shown are any wires or other electrical contacts, or protective coatings that might prove beneficial.

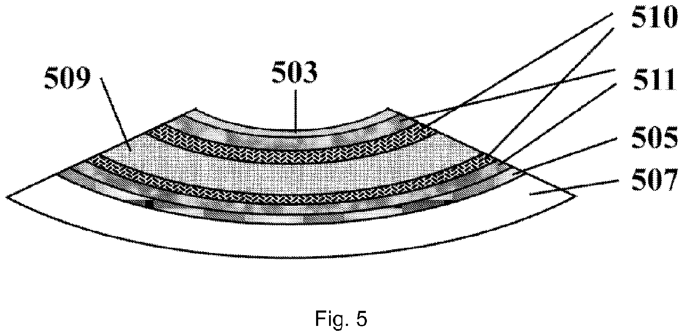

Referring to Fig. 5, which provides a cross-sectional view of a curved semitransparent object coated with a semitransparent OPV device, comprising one or more cells connecting in series and/or parallel, produced via the pressure-sensitive adhesive method, the base layer 507 includes an arbitrary semitransparent object, such as a window. Laminated onto the object via the pressure-sensitive adhesive 405 using stretching and press-forming, with or without vacuum assistance in removing entrained air, is the multilayer semitransparent OPV device. To enable a semitransparent device, both electrodes 511 must be inherently flexible TCs; they can be identical, or different. On top of the first TC electrode is one of the charge-collection layers 510 (hole or electron, depending on device polarity). The photoactive (BHJ) layer 509, is sandwiched between the first and second charge collection layer, which, in this exemplary embodiment, necessarily must be different materials to ensure opposite polarity selectivity. On top of the second charge-collection layer 510, is the second TC 411. Finally, on top is the very thin, highly flexible substrate 503. The unique and inherent flexibility of OPV devices allows lamination onto curved surfaces without significant disruption of device performance, and enables production of three-dimensional organic optoelectronic devices that would be difficult to produce via conventional coating techniques due to realities of capillarity flow on curved surfaces. This method enables OPV devices to be laminated onto surfaces of arbitrary and changing curvature, which would be impossible via conventional solution coating techniques. While, in this exemplary embodiment, the method is necessarily a discrete process for the fabrication of each individual object, the intermediate transfer film (see Fig. 1) used to transfer the completed OPV device onto the object can be produced in a continuous, high-throughput methodology. Not shown are any wires or other electrical contacts, or protective coatings that might prove beneficial.

The present invention has been described herein in terms of several preferred embodiments. However, modifications and additions to these embodiments will become apparent to those of ordinary skill in the art upon a reading of the foregoing description. It is intended that all such modifications and additions comprise a part of the present invention to the extent that they fall within the scope of the several claims appended hereto.

## Claims

1. A transfer film for the fabrication of organic photovoltaic device coatings for three-dimensional objects, the film comprising:
a support substrate (101),
a flexible transparent substrate (103);
a transfer release layer (102) laminated between the support substrate and the flexible transparent substrate, wherein the transfer release layer facilitates removal of the support substrate and the transfer release layer from the flexible transparent substrate (103);
a flexible multilayer organic photovoltaic device (104) coated on the flexible transparent substrate, wherein the multilayer organic photovoltaic device (104) is located on an opposite side of the flexible transparent substrate (103) from the transfer release layer (102), and
a pressure-sensitive adhesive (105, 505) coated on the multilayer organic photovoltaic device (104), wherein the pressure-sensitive adhesive (105, 505) is on an opposite side of the multilayer organic photovoltaic device (104) from the flexible transparent substrate (103, 503),
wherein the flexible multilayer organic photovoltaic device (104) comprises:
a first flexible transparent conductor electrode (511) in contact with the pressure-sensitive adhesive (105, 505);
a second flexible transparent conductor electrode (511) in contact with the flexible transparent substrate (103, 503);
a first flexible charge-collection layer (510) in contact with the first flexible conductor electrode (511);
a second flexible charge-collection layer (510) in contact with the second flexible transparent conductor electrode (511), wherein a first of the first flexible charge-collection layer (510) and the second flexible charge-collection layer (510) comprises an electron-collection layer and a second of the first flexible charge-collection layer (510) and the second flexible charge-collection layer (510) comprises a hole-collection layer; and
a flexible photoactive layer (509) sandwiched between the first flexible charge-collection layer (510) and the second flexible charge-collection layer (510);
wherein the multilayer organic photovoltaic device (104) is semi-transparent, and wherein the pressure-sensitive adhesive (105, 505) is configured to adhere and conform the multilayer organic photovoltaic device (104) to a three-dimensional surface (507) upon removal of the support substrate (101) and the transfer release layer (102) from the flexible transparent substrate (103, 503) such that light is capable of passing through the flexible transparent substrate (103,503), the multilayer organic photovoltaic device (104), and the pressure-sensitive adhesive (105, 505) from either side.

2. The transfer film of claim 1, wherein the support substrate is a rigid material.

3. The transfer film of claim 1, wherein the support substrate is a flexible material compatible with roll-to-roll manufacturing techniques.

4. The transfer film of claim 1, wherein the flexible multilayer organic photovoltaic device comprises one or more cells connected in series and/or in parallel.

5. The transfer film of claim 1, wherein the flexible transparent substrate is polyethylene terephthalate (PET).

6. The transfer film of claim 2, wherein the rigid material includes one of glass and metal.

7. The transfer file of claim 3, wherein the flexible material is one of a polymer and a metal foil compatible with roll-to-roll manufacturing techniques.

8. A method of manufacturing the transfer film of any preceding claim, the method comprising the steps of:
coating the support substrate with the transfer release layer;
laminating the support substrate and the transfer release layer with the flexible transparent substrate;
coating the flexible transparent substrate with the multilayer organic photovoltaic device; and
coating the semi-transparent multilayer organic photovoltaic device with the pressure-sensitive adhesive,
wherein all steps are performed using roll-to-roll manufacturing.

## Patentansprüche

1. Eine Transferfolie für die Herstellung von organischen Photovoltaikvorrichtungsbeschichtungen für dreidimensionale Objekte, wobei die Folie Folgendes beinhaltet:
ein Trägersubstrat (101),
ein flexibles transparentes Substrat (103);
eine Transferfreigabeschicht (102), die zwischen dem Trägersubstrat und dem flexiblen transparenten Substrat laminiert ist, wobei die Transferfreigabeschicht die Entfernung des Trägersubstrats und der Transferfreigabeschicht von dem flexiblen transparenten Substrat (103) erleichtert;
eine flexible mehrschichtige organische Photovoltaikvorrichtung (104), die auf dem flexiblen transparenten Substrat aufgeschichtet ist, wobei sich die mehrschichtige organische Photovoltaikvorrichtung (104) auf einer gegenüberliegenden Seite des flexiblen transparenten Substrats (103) von der Transferfreigabeschicht (102) befindet, und
einen druckempfindlichen Klebstoff (105, 505), der auf der mehrschichtigen organischen Photovoltaikvorrichtung (104) aufgeschichtet ist, wobei sich der druckempfindliche Klebstoff (105, 505) auf einer gegenüberliegenden Seite der mehrschichtigen organischen Photovoltaikvorrichtung (104) von dem flexiblen transparenten Substrat (103, 503) befindet,
wobei die flexible mehrschichtige organische Photovoltaikvorrichtung (104) Folgendes beinhaltet:
eine erste flexible transparente Leiterelektrode (511) in Kontakt mit dem druckempfindlichen Klebstoff (105, 505);
eine zweite flexible transparente Leiterelektrode (511) in Kontakt mit dem flexiblen transparenten Substrat (103, 503);
eine erste flexible Ladungssammlungsschicht (510) in Kontakt mit der ersten flexiblen Leiterelektrode (511);
eine zweite flexible Ladungssammlungsschicht (510) in Kontakt mit der zweiten flexiblen transparenten Leiterelektrode (511), wobei eine erste der ersten flexiblen Ladungssammlungsschicht (510) und der zweiten flexiblen Ladungssammlungsschicht (510) eine Elektronensammlungsschicht beinhaltet und eine zweite der ersten flexiblen Ladungssammlungsschicht (510) und der zweiten flexiblen Ladungssammlungsschicht (510) eine Lochsammlungsschicht beinhaltet; und
eine flexible photoaktive Schicht (509), die zwischen der ersten flexiblen Ladungssammlungsschicht (510) und der zweiten flexiblen Ladungssammlungsschicht (510) eingeschoben ist;
wobei die mehrschichtige organische Photovoltaikvorrichtung (104) halbtransparent ist und wobei der druckempfindliche Klebstoff (105, 505) konfiguriert ist, um die mehrschichtige organische Photovoltaikvorrichtung (104) bei Entfernen des Trägersubstrats (101) und der Transferfreigabeschicht (102) von dem flexiblen transparenten Substrat (103, 503) auf eine dreidimensionale Oberfläche (507) zu kleben und daran anzugleichen, sodass Licht fähig ist, durch das flexible transparente Substrat (103, 503), die mehrschichtige organische Photovoltaikvorrichtung (104) und den druckempfindlichen Klebstoff (105, 505) von beiden Seiten durchzugehen.

2. Transferfolie gemäß Anspruch 1, wobei das Trägersubstrat ein starres Material ist.

3. Transferfolie gemäß Anspruch 1, wobei das Trägersubstrat ein flexibles Material ist, das mit Rolle-zu-Rolle-Fertigungstechniken kompatibel ist.

4. Transferfolie gemäß Anspruch 1, wobei die flexible mehrschichtige organische Photovoltaikvorrichtung eine oder mehrere Zellen beinhaltet, die in Reihe und/oder parallel geschaltet sind.

5. Transferfolie gemäß Anspruch 1, wobei das flexible transparente Substrat Polyethylenterephthalat (PET) ist.

6. Transferfolie gemäß Anspruch 2, wobei das starre Material eines von Glas und Metall umfasst.

7. Transferfolie gemäß Anspruch 3, wobei das flexible Material eines von einer Polymer- und einer Metallfolie ist, die mit Rolle-zu-Rolle-Fertigungstechniken kompatibel sind.

8. Ein Verfahren für die Fertigung der Transferfolie gemäß einem der vorhergehenden Ansprüche, wobei das Verfahren die folgenden Schritte beinhaltet:
Beschichten des Trägersubstrats mit der Transferfreigabeschicht;
Laminieren des Trägersubstrats und der Transferfreigabeschicht mit dem flexiblen transparenten Substrat;
Beschichten des flexiblen transparenten Substrats mit der mehrschichtigen organischen Photovoltaikvorrichtung; und
Beschichten der halbtransparenten mehrschichtigen organischen Photovoltaikvorrichtung mit dem druckempfindlichen Klebstoff,
wobei alle Schritte unter Verwendung von Rolle-zu-Rolle-Fertigung durchgeführt werden.

## Revendications

1. Un film de transfert pour la réalisation de revêtements de dispositif photovoltaïque organique pour objets tridimensionnels, le film comprenant :
un substrat de support (101),
un substrat transparent souple (103) ;
une couche antiadhésive de transfert (102) stratifiée entre le substrat de support et le substrat transparent souple, la couche antiadhésive de transfert facilitant le retrait du substrat de support et de la couche antiadhésive de transfert par rapport au substrat transparent souple (103) ;
un dispositif photovoltaïque organique multicouche souple (104) appliqué en revêtement sur le substrat transparent souple, le dispositif photovoltaïque organique multicouche (104) étant situé sur un côté opposé du substrat transparent souple (103) par rapport à la couche antiadhésive de transfert (102), et
un adhésif sensible à la pression (105, 505) appliqué en revêtement sur le dispositif photovoltaïque organique multicouche (104), l'adhésif sensible à la pression (105, 505) étant sur un côté opposé du dispositif photovoltaïque organique multicouche (104) par rapport au substrat transparent souple (103, 503),
dans lequel le dispositif photovoltaïque organique multicouche souple (104) comprend :
une première électrode conductrice transparente souple (511) en contact avec l'adhésif sensible à la pression (105, 505) ;
une deuxième électrode conductrice transparente souple (511) en contact avec le substrat transparent souple (103, 503) ;
une première couche de collecte de charges souple (510) en contact avec la première électrode conductrice souple (511) ;
une deuxième couche de collecte de charges souple (510) en contact avec la deuxième électrode conductrice transparente souple (511), une première couche parmi la première couche de collecte de charges souple (510) et la deuxième couche de collecte de charges souple (510) comprenant une couche de collecte d'électrons et une deuxième couche parmi la première couche de collecte de charges souple (510) et la deuxième couche de collecte de charges souple (510) comprenant une couche de collecte de trous ; et
une couche photoactive souple (509) intercalée entre la première couche de collecte de charges souple (510) et la deuxième couche de collecte de charges souple (510) ;
dans lequel le dispositif photovoltaïque organique multicouche (104) est semi-transparent, et dans lequel l'adhésif sensible à la pression (105, 505) est configuré pour faire adhérer et conformer le dispositif photovoltaïque organique multicouche (104) à une surface tridimensionnelle (507) lors du retrait du substrat de support (101) et de la couche antiadhésive de transfert (102) par rapport au substrat transparent souple (103, 503) de telle sorte que de la lumière soit capable de traverser le substrat transparent souple (103, 503), le dispositif photovoltaïque organique multicouche (104), et l'adhésif sensible à la pression (105, 505) depuis chaque côté.

2. Le film de transfert de la revendication 1, dans lequel le substrat de support est un matériau rigide.

3. Le film de transfert de la revendication 1, dans lequel le substrat de support est un matériau souple compatible avec des techniques de fabrication rouleau à rouleau.

4. Le film de transfert de la revendication 1, dans lequel le dispositif photovoltaïque organique multicouche souple comprend une ou plusieurs cellules connectées en série et/ou en parallèle.

5. Le film de transfert de la revendication 1, dans lequel le substrat transparent souple est du polyéthylène téréphtalate (PET).

6. Le film de transfert de la revendication 2, dans lequel le matériau rigide inclut un matériau parmi du verre et du métal.

7. Le film de transfert de la revendication 3, dans lequel le matériau souple est un matériau parmi un polymère et une feuille métallique compatibles avec des techniques de fabrication rouleau à rouleau.

8. Un procédé de fabrication du film de transfert de n'importe quelle revendication précédente, le procédé comprenant les étapes :
d'application en revêtement, sur le substrat de support, de la couche antiadhésive de transfert ;
de stratification du substrat de support et de la couche antiadhésive de transfert avec le substrat transparent souple ;
d'application en revêtement, sur le substrat transparent souple, du dispositif photovoltaïque organique multicouche ; et
d'application en revêtement, sur le dispositif photovoltaïque organique multicouche semi-transparent, de l'adhésif sensible à la pression,
dans lequel toutes les étapes sont effectuées à l'aide d'une fabrication rouleau à rouleau.
